# EUROPEAN PATENT SPECIFICATION

(11) **EP 0 630 053 B1**
(45) Date of publication and mention of the grant of the patent: **12.11.1997**
(21) Application number: 94304131.9
(22) Date of filing: 08.06.1994
(51) Int. Cl.: H01L 29/737

(54) **Heterojunction type bipolar transistor**
Heteroübergang-Bipolartransistor
Transistor bipolaire à hétérojonction

(30) Priority: 08.06.1993 JP 137222/93
(43) Date of publication of application: 21.12.1994
(73) Proprietor: SHARP KABUSHIKI KAISHA, Osaka 545 (JP)
(72) Inventor: Twynam, John Kevin, Tenri-shi, Nara-ken (JP); Shinozaki, Toshiyuki, Tenri-shi, Nara-ken (JP); Yagura, Motoji, Tenri-shi, Nara-ken (JP); Kinosada, Toshiaki, Izumi-shi, Osaka-fu (JP)
(74) Representative: Brown, Kenneth Richard

(56) References cited:
- EP-A- 0 297 886
- EP-A- 0 529 772
- EP-A- 0 562 272
- IEEE TRANSACTIONS ON ELECTRON DEVICES, vol.38, no.2, February 1991, NEW YORK US pages 185 - 196 G. GAO ET AL. 'Emitter ballasting resistor design for, and current handling capability of AlGaAs/GaAs power heterojunction bipolar transistors'
- PATENT ABSTRACTS OF JAPAN vol. 15, no. 185 (E-1066) 13 May 1991 & JP-A-03 046 334

## Description

### Description for the following Contracting States : DE, FR, GB

### BACKGROUND OF THE INVENTION

### Field of the Invention

The present invention relates to heterojunction type bipolar transistors, and more particularly, to an improvement in a bipolar transistor having a ballast resistance.

### Description of the Background Art

A conventional power control heterojunction type bipolar transistor is liable to extraordinarily generate heat when a control current is increased. The extraordinary heat generation is caused by a positive feedback that a transistor generates heat by a collector current at the time of operation, the collector current is increased by the heat generated, and that the increased collector current further increases heat generation. In order to prevent such extraordinary heat generation, as is disclosed in JP-A- 3-46334, a heterojunction type bipolar transistor is known including as a ballast resistance a GaAs layer having the same conductivity type as that of an emitter layer and an impurity concentration lower than that of the emitter layer.

In Fig. 10, a heterojunction type AlGaAs/GaAs bipolar transistor as disclosed in JP-A-3-46334 is schematically shown in section. In this transistor, an n⁺-GaAs subcollector layer 82 is formed on a semi-insulating GaAs substrate 81. Subcollector layer 82 may have a thickness of 500nm (5000Å) and an n type carrier concentration of n=5x10¹⁸cm⁻³, for example. On subcollector layer 82, formed are an n-GaAs collector layer 83 and a collector electrode Ec. Collector layer 83 may have a thickness of 500nm(5000Å) and a carrier concentration of n=5x10¹⁶cm⁻³.

A p⁺-GaAs base layer 84 is formed on collector layer 83. Base layer 84 may have a thickness of 70nm(700Å) and a p type carrier concentration of p=4x10¹⁹cm⁻³. On base layer 84, formed are a base electrode Eb and an n-Al_{0.3}Ga_{0.7}As emitter layer 85. Emitter layer 85 may have a thickness of 80nm(800Å) and a carrier concentration of n=5x10¹⁷cm⁻³.

An n⁻-GaAs ballast resistance layer 86 is formed on emitter layer 85. Ballast resistance layer 86 may have a thickness of 200nm(2000Å) and a carrier concentration of n=10¹⁶cm⁻³ . On ballast resistance layer 86, sequentially stacked are an n⁺-GaAs contact layer 87 and an emitter electrode Ee. Contact layer 87 may have a thickness of 100nm(1000Å) and a carrier concentration of n=5x10¹⁸cm⁻³.

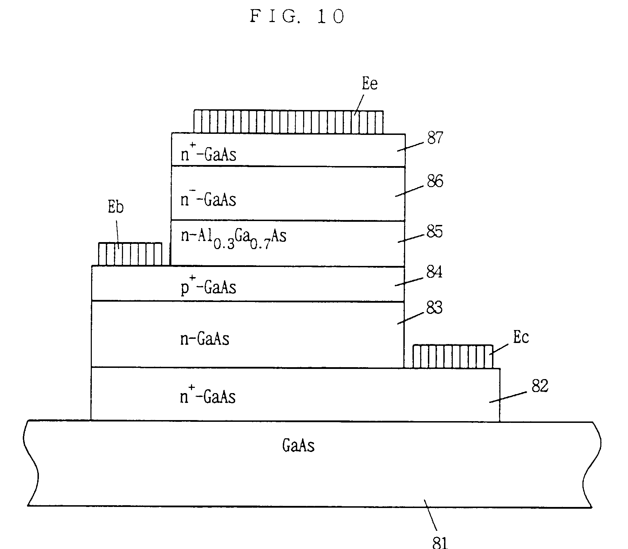

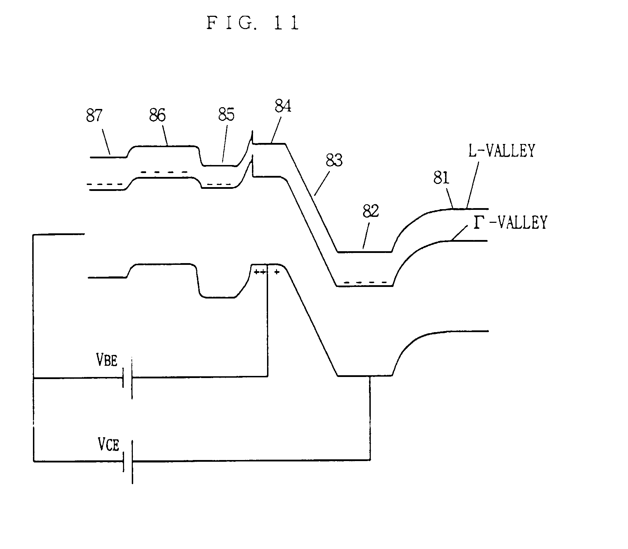

Fig. 11 schematically shows an energy band structure corresponding to the sectional structure of the transistor of Fig. 10. In Figs. 11 and 10, the same or corresponding portions are labeled with the same reference characters. In the energy band structure of Fig. 11, a base/emitter voltage V_{BE} is applied between base layer 84 and contact layer 87, and a collector/emitter voltage V_{CE} is applied between subcollector layer 82 and contact layer 87. A Γ valley and an L valley having an energy level higher than the Γ valley are shown as conduction bands. As described above, in order to prevent extraordinary heat generation of the heterojunction type AlGaAs/GaAs bipolar transistor, a GaAs layer is usually used as a ballast resistance having the same conductivity type as that of the emitter layer and a carrier concentration lower than that of the emitter layer.

In order to operate the heterojunction type AlGaAs/GaAs bipolar transistor stably, it is necessary to block a positive feedback causing extraordinary heat generation. To do so, it is necessary to prevent increase in a collector current caused by a rise of temperature of the transistor. In order to prevent such increase in a collector current by a rise of temperature, a ballast resistance as described above is used. Since the ballast resistance also serves as a parasitic resistance of the transistor, however, the ballast resistance deteriorates the characteristics of the bipolar transistor.

Therefore, it is desired to have a ballast resistance having a low resistance value in a normal operative state where the temperature of the transistor is low, and having a high resistance value in a state of extraordinary heat generation where the temperature of the transistor is high. In other words, a ballast resistance having a large temperature coefficient of a resistance value is desired. However, the conventionally used GaAs ballast resistance layer has a relatively small temperature coefficient of approximately 0.001°C.

EP-A-0 562 272, published on 29th September 1993, constitutes a state of the art under Article 54(3) EPC for the designated states DE, FR and GB. This document discloses a bipolar transistor including an active emitter layer of AlₓGaj₁₋ₓAs, where x ≤ 0.4, interposed between a GaAs base layer and an emitter ballast layer of Al_{y}Ga_{1-y}As, where y > 0.4.

### SUMMARY OF THE INVENTION

It is an object of the present invention to provide a heterojunction type bipolar transistor having a ballast resistance of an excellent characteristic.

The present invention provides the heterojunction type AlGaAs/GaAs bipolar transistor defined by claim 1.

The sub-claims 2 to 8 relate to embodiments of the invention.

In the AlGaAs/GaAs bipolar transistor according to the present invention, the n-Al_{y}Ga_{1-y}As ballast resistance layer has a positive temperature coefficient (dR/dT) x (1/R) larger than that of the n⁻-GaAs ballast resistance layer, wherein R is a resistance and T is a temperature. In the n-Al_{y}Ga_{1-y}As ballast resistance layer, by selecting the Al concentration y, the energy gap between valleys of a conduction band can be adjusted. When the energy gap between valleys is small, more electrons are thermally excited on the upper valley with increase in the temperature. Effective mass of electrons increases, and mobility of the electrons decreases, resulting in increase in resistance of the n-Al_{y}Ga_{1-y}As ballast resistance layer.

More specifically, the n-Al_{y}Ga_{1-y}As ballast resistance layer has a substantially larger resistance in high temperature as compared to the conventional n⁻-GaAs ballast resistance layer. Therefore, it is possible to more reliably prevent extraordinary heat generation caused by a positive feedback of the collector current in high temperature, making it possible to implement thermally stable operation of the bipolar transistor.

### BRIEF DESCRIPTION OF THE DRAWINGS

Fig. 1 is a schematic sectional view showing an AlGaAs/GaAs bipolar transistor according to one embodiment of the present invention.

Fig. 2 is a diagram showing an energy band structure corresponding to the sectional structure of the transistor of Fig. 1.

Fig. 3 is a graph showing I_{C}-V_{CE} characteristics in such a transistor as shown in Fig. 1.

Fig. 4 is a graph showing the I_{C}-V_{CE} characteristics in a conventional transistor not including a ballast resistance layer.

Fig. 5 is a graph showing an energy gap between a conduction band and a valence band depending on an Al concentration y in n-Al_{y}Ga_{1-y}As.

Fig. 6 is a diagram of an energy band showing electron distribution in n-GaAs at 300K and 400K.

Fig. 7 is a diagram of an energy band showing electron distribution in n-Al_{0.35}Ga_{0.65}As at 300K and 400K.

Fig. 8 is a graph showing an influence of the Al concentration y in n-Al_{y}Ga_{1-y}As on the relationship between temperature and resistivity.

Fig. 9 is a graph showing an influence of the Al concentration y in n-Al_{y}Ga_{1-y}As on the relationship between a temperature coefficient of resistance and temperature.

Fig. 10 is a schematic sectional view showing a conventional AlGaAs/GaAs bipolar transistor including a ballast resistance layer.

Fig. 11 is a diagram showing an energy band structure corresponding to the sectional structure of Fig. 10.

### DESCRIPTION OF THE PREFERRED EMBODIMENTS

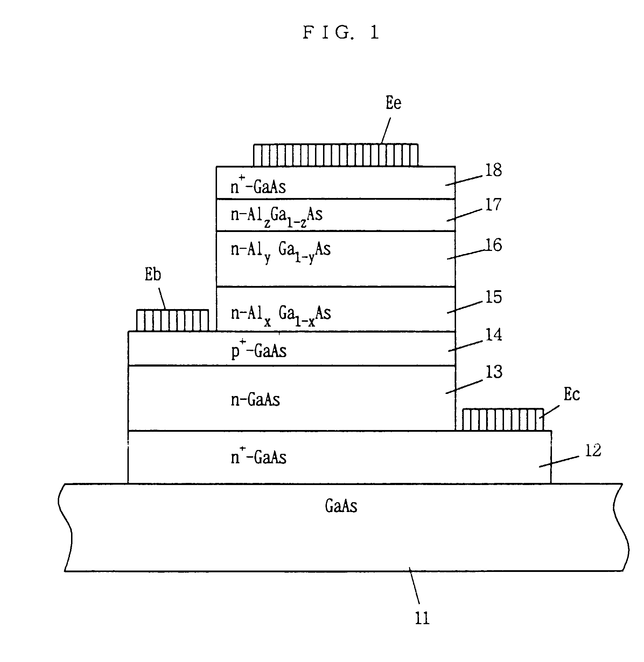

Fig. 1 schematically shows a sectional structure of a heterojunction type AlGaAs/GaAs bipolar transistor according to one embodiment of the present invention. In this transistor, on a semi-insulating GaAs substrate 11, formed is an n⁺-GaAs subcollector layer 12. Subcollector layer 12 may have a thickness of 500nm(5000Å) and an n type carrier concentration of n=5x10¹⁸cm⁻³, for example. On subcollector layer 12, formed are an n-GaAs collector layer 13 and a collector electrode Ec. Collector layer 13 may have a thickness of 500nm(5000Å) and a carrier concentration of n=5x10¹⁶cm⁻³.

On collector layer 13, formed is a p⁺-GaAs base layer 14. Base layer 14 may have a thickness of 70nm(700Å) and a p type carrier concentration of p=4x10¹⁹cm⁻³.

On base layer 14, formed is an n-AlₓGa₁₋ₓAs emitter layer 15. Emitter layer 15 preferably has an Al concentration of x=0.3. Emitter layer 15 may have a thickness of 80nm(800Å) and a carrier concentration of n=5x10¹⁷cm⁻³.

An n-Al_{y}Ga_{1-y}As ballast resistance layer 16 is formed on emitter layer 15. Ballast resistance layer 16 preferably has an Al concentration of y=0.35. Ballast resistance layer 16 may have a thickness of 200nm(2000Å) and a carrier concentration of n=10¹⁷cm⁻³.

An n-Al_{z}Ga_{1-z}As graded layer 17 is formed on ballast resistance layer 16. Graded layer 17 may have a thickness of 50nm(500Å) and a carrier concentration of n=10¹⁸cm⁻³. On graded layer 17, formed is an n⁺-GaAs contact layer 18 to be connected to the emitter electrode Ee. Contact layer 18 may have a thickness of 100nm(1000Å) and a carrier concentration of n=5x10¹⁸cm⁻³.

Ballast resistance layer 16 has a resistance higher than that of emitter layer 15. The resistance of ballast resistance layer 16 can be increased by lowering the carrier concentration as compared to emitter layer 15. The resistance of ballast resistance layer 16 can be increased, however, by increasing the Al concentration y a little. The carrier concentration does not necessarily have to be lowered. More specifically, ballast resistance layer 16 must have a resistance higher than that of emitter layer 15, but the carrier concentration in the ballast resistance layer does not necessarily have to be lowered as compared to the emitter layer.

Graded layer 17 is provided to reduce discontinuity in the energy band between ballast resistance layer 16 and contact layer 18. Therefore, the Al concentration z in graded layer 17 is gradually changed from z=y on the side in contact with ballast resistance layer 16 to z=0 on the side in contact with contact layer 18. The Al concentration z may be changed in a linear, curved or stepped manner. Although graded layer 17 is preferably provided to reduce discontinuity in the energy band between ballast resistance layer 16 and contact layer 18 as described above, it is not necessarily required.

The heterojunction type AlGaAs/GaAs bipolar transistor as shown in Fig. 1 can be formed with wellknown methods, an MOCVD (Metal Organic Chemical Vapor Deposition) method and a mesa etching method. Silicon can be used as an n type dopant, and carbon can be used as a p type dopant.

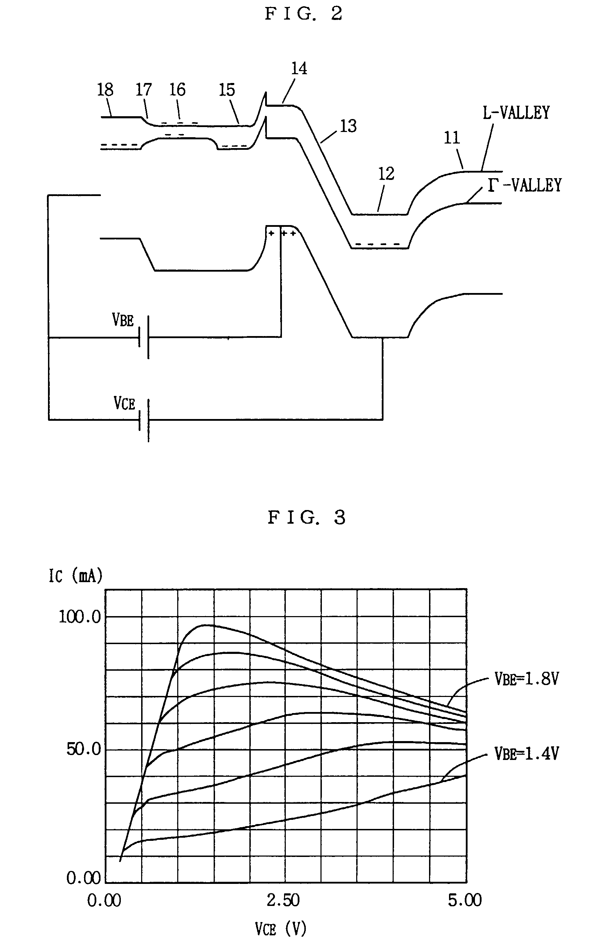

Fig. 2 shows an energy band profile corresponding to the sectional structure of such a transistor as shown in Fig. 1. In Fig. 2, the base/emitter voltage V_{BE} is applied between base layer 14 and contact layer 18, and the collector/emitter voltage V_{CE} is applied between subcollector layer 12 and contact layer 18. A Γ valley and an L valley having an energy level higher than that of the Γ valley are shown as conduction bands. In comparison of Figs. 2 and 11, energy levels of the Γ valley and the L valley in n-Al_{y}Ga_{1-y}As ballast resistance layer 16 are more closely adjacent to each other as compared in an n⁻-GaAs ballast resistance layer 86. Therefore, as compared to the case of n⁻-GaAs ballast resistance layer 86, electrons are more easily excited from the Γ valley at a lower level to the L valley at a higher level with increase in temperature in n-Al_{y}Ga_{1-y}As ballast resistance layer 16. It is understood that because of reduction of mobility due to increase in effective mass of excited electrons, n-Al_{y}Ga_{1-y}As ballast resistance layer 16 has a rapid increase in resistance with rise of temperature as compared to n⁻-GaAs ballast resistance layer 86.

Fig. 3 is a graph showing characteristics of such a transistor as shown in Fig. 1. The abscissa denotes the collector/emitter voltage V_{CE}, and the ordinate denotes the collector current I_{C} (mA). In Fig. 3, n-AlₓGa₁₋ₓAs emitter layer 15 has an Al concentration of x=0.3, and n-AI_{y}Ga_{1-y}As ballast resistance layer 16 has an Al concentration of y=0.35. Various curves in Fig. 3 show I_{C}-V_{CE} characteristics of the transistor under various base/emitter voltages V_{BE}. More specifically, in a region where the collector/emitter voltage V_{CE} is relatively low, the collector current I_{C} increases in proportion to V_{CE}. However, when the collector/emitter voltage V_{CE} exceeds a certain level, the collector current I_{C} or the rate of increase of the collector current decreases, and extraordinary heat generation of the transistor is prevented.

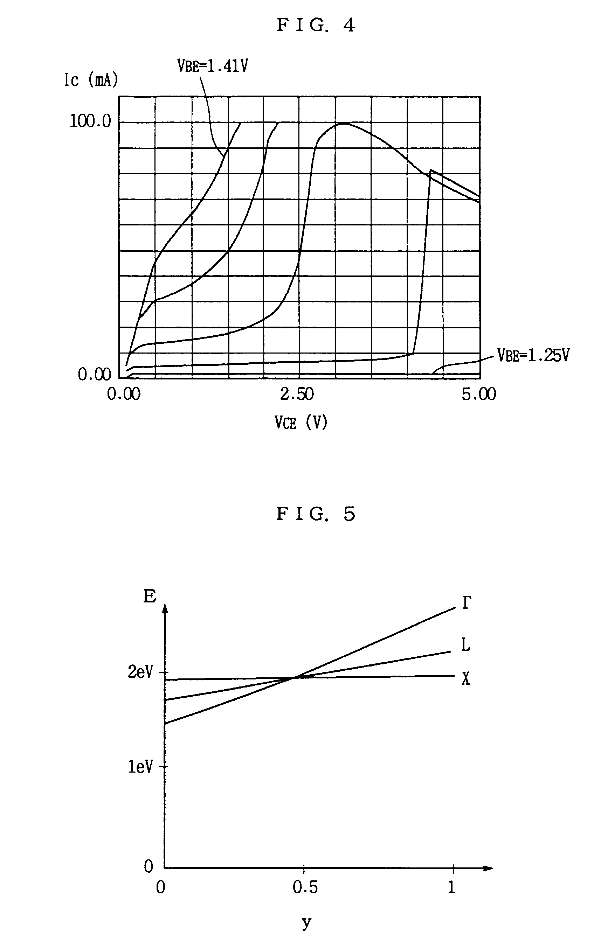

Fig. 4 is a graph similar to that of Fig. 3, showing the I_{C}-V_{CE} characteristics in the AlGaAs/GaAs bipolar transistor not including ballast resistance layer 16. In the transistor shown in Fig. 4, the collector current I_{C} rapidly increases with increase in the collector/emitter voltage V_{CE}. It is understood that the transistor has unstable characteristics. In Fig. 4, two curves terminate at I_{C}=100.0mA. This is because a protecting circuit of the measurement device worked at that collector current value. Two other curves show decrease in collector current at high voltage V_{CE}. This is due to base current limiting protection circuitry in the measurement device. As is clear from the above, the heterojunction type bipolar transistor not having a ballast resistance layer is likely to generate extraordinary heat due to structural nonuniformity. In particular, it is difficult to obtain thermally stable characteristics without ballast resistance in a transistor having a plurality of emitter electrodes in a shape of finger.

According to the analysis of the inventors, an n-Al_{y}Ga_{1-y}As ballast resistance layer may have a temperature coefficient larger than that of a conventional n⁻-GaAs ballast resistance layer in a region of a temperature up to approximately 500K where an AlGaAs/GaAs bipolar transistor is usually used. The n-Al_{y}Gal_{1-y}As ballast resistance layer may have a temperature coefficient approximately ten times larger than that of the n⁻-GaAs ballast resistance layer at approximately 350K. The Al concentration y in the n-Al_{y}Ga_{1-y}As ballast resistance layer has only to be in the range of 0<y≤0.4, more preferably in the range of 0.2<y≤0.4, and most preferably y=0.35. Description will be given of a reason therefore hereinafter.

In the graph of Fig. 5, shown is change of energy levels of three kinds of conduction bands of the Γ valley the L valley and the X valley in n-Al_{y}Ga_{1-y}As ballast resistance layer 16. The abscissa represents the Al concentration y in the n-Al_{y}Ga_{1-y}As ballast resistance layer, and the ordinate represents an energy difference E between the top of a valence band and the bottom of three kinds of conduction bands. When the Al concentration y is in the range of 0<y≤0.45, the energy level of the Γ valley is lower than those of the L valley and the X valley. As the Al concentration y approaches 0.45, the energy difference between valleys becomes small. More specifically, at certain electron concentration and temperature, it becomes easier to excite electrons from the Γ valley to a valley at a higher level as the Al concentration y increases. As a result, the ballast resistance rapidly increases. However, if the Al concentration y exceeds 0.45, there is no energy difference between valleys and the ballast resistance will not increase.

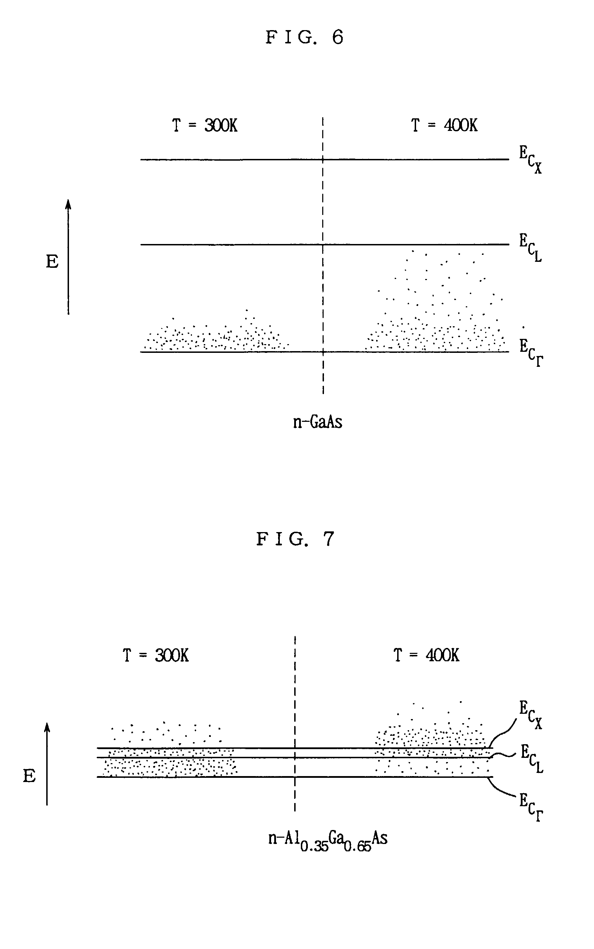

Fig. 6 schematically shows a state of distribution of electrons in n⁻-GaAs ballast resistance layer 86. At the temperature of 300K, all the electrons are distributed in a lower region of the Γ valley E_{CΓ}, and no electrons are distributed in the L valley E_{CL} and the X valley E_{CX}. Even at the temperature of 400K, most electrons are distributed in the Γ valley.

Fig. 7 is a diagram similar to that of Fig. 6, showing a state of distribution of electrons in n-Al_{0.35}Ga_{0.65}As ballast resistance layer 16. In Fig. 7, as compared to the case of Fig. 6, the energy gap between valleys is substantially reduced. Therefore, even at the temperature of 300K, electrons are not distributed only in the Γ valley. Thermally excited electrons are also distributed in the L valley and the X valley. At the temperature of 400K, electrons are greater in number in the L valley and the X valley than in the Γ valley. The effective mass of electrons is greater in the L valley and the X valley than in Γ valley, and the average mobility of electrons excited in the Γ valley and the X valley is reduced. As a result, the resistance of n-Al_{0.35}Ga_{0.65}As ballast resistance layer 16 rapidly increases.

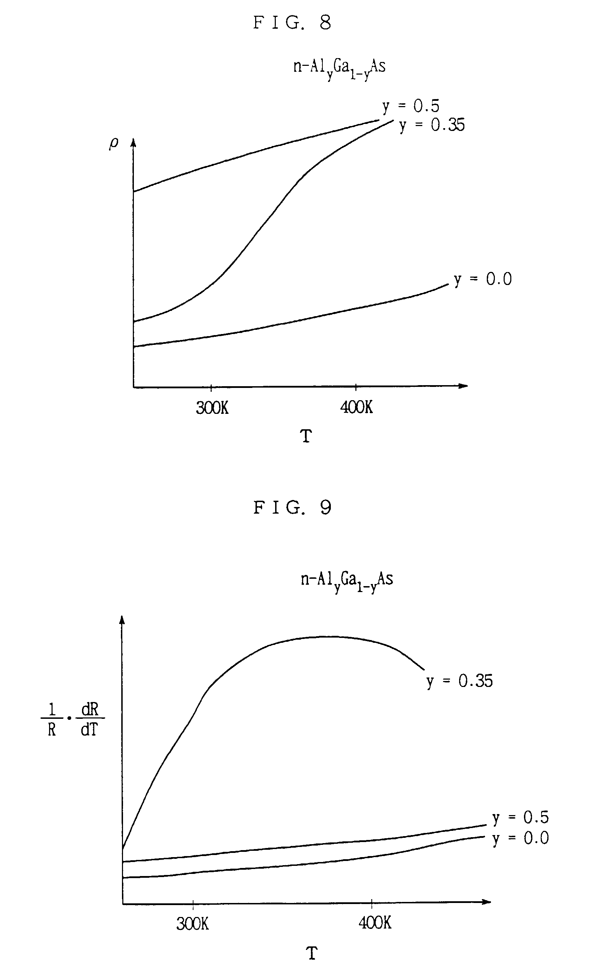

In the graph of Fig. 8, the relationship between temperature T and resistivity ρ in n-Al_{y}Ga_{1-y}As is schematically shown. The abscissa represents the temperature T, and the ordinate represents the resistivity ρ. As is clear from Fig. 8, when the Al concentration is y=0.0, the resistivity ρ in a region of a low temperature has a small value. Even if the temperature rises, the resistivity ρ does not increase so much. When the Al concentration is y=0.35, the resistivity ρ in a region of a low temperature has a small value. However, the resistivity ρ rapidly increases with a rise of the temperature. When the Al concentration is y=0.5, the resistivity ρ has a relatively large value even in a region of a low temperature. The resistivity does not increase so much even if the temperature rises.

In the graph of Fig. 9, the relationship between the temperature T and the temperature coefficient (dR/dT) x (1/R) of the resistance R in n-Al_{y}Ga_{1-y}As is shown. The abscissa represents the temperature T, and the ordinate represents the temperature coefficient (dR/dT) x (1/R). When the Al concentration is y=0.0 or y=0.5, the temperature coefficient of the resistance R slightly increases with a rise of the temperature. On the other hand, when the Al concentration is y = 0.35, the temperature coefficient of the resistance R rapidly increases with a rise of the temperature. The temperature coefficient reaches the peak between 300K and 400K, and then decreases as the temperature increases. It will be understood from Fig. 9 that the temperature coefficient of the resistance in ballast resistance layer 16 can be increased by appropriately selecting the Al concentration y in n-Al_{y}Ga_{1-y}As.

In selecting the Al concentration y in n-Al_{y}Ga_{1-y}As ballast resistance layer 16, the Al concentration y does not have to be constant in the direction of thickness of ballast resistance layer 16. The Al concentration y may be changed if desired.

As described above, in the heterojunction type AlGaAs/GaAs bipolar transistor according to the present invention, the n-Al_{y}Ga_{1-y}As ballast resistance layer has a preferably low resistance in a region of a low temperature, and has a sufficiently high resistance in a state of a high temperature. Therefore, non-uniformed current distribution in the transistor can be prevented. As a result, an AlGaAs/GaAs bipolar transistor of high reliability can be obtained which can implement thermally stable operation by having a low parasitic resistance in a state of a low temperature, and by preventing extraordinary heat generation in a state of high temperature.

Although an embodiment of the present invention has been described and illustrated in detail, it is clearly understood that the same is by way of illustration and example only and is not to be taken by way of limitation, the scope of the present invention being defined by the terms of the appended claims.

### Description for the following Contracting States : SE

### BACKGROUND OF THE INVENTION

### Field of the Invention

The present invention relates to heterojunction type bipolar transistors, and more particularly, to an improvement in a bipolar transistor having a ballast resistance.

### Description of the Background Art

A conventional power control heterojunction type bipolar transistor is liable to extraordinarily generate heat when a control current is increased. The extraordinary heat generation is caused by a positive feedback that a transistor generates heat by a collector current at the time of operation, the collector current is increased by the heat generated, and that the increased collector current further increases heat generation. In order to prevent such extraordinary heat generation, as is disclosed in JP-A- 3-46334, a heterojunction type bipolar transistor is known including as a ballast resistance a GaAs layer having the same conductivity type as that of an emitter layer and an impurity concentration lower than that of the emitter layer.

In Fig. 10, a heterojunction type AlGaAs/GaAs bipolar transistor as disclosed in JP-A-3-46334 is schematically shown in section. In this transistor, an n⁺-GaAs subcollector layer 82 is formed on a semi-insulating GaAs substrate 81. Subcollector layer 82 may have a thickness of 500nm(5000Å) and an n type carrier concentration of n=5x10¹⁸ cm⁻³, for example. On subcollector layer 82, formed are an n-GaAs collector layer 83 and a collector electrode Ec. Collector layer 83 may have a thickness of 500nm(5000Å) and a carrier concentration of n=5x10¹⁶cm⁻³.

A p⁺-GaAs base layer 84 is formed on collector layer 83. Base layer 84 may have a thickness of 70nm(700Å) and a p type carrier concentration of p=4x10¹⁹cm⁻³. On base layer 84, formed are a base electrode Eb and an n-Al₀₃Ga_{0.7}As emitter layer 85. Emitter layer 85 may have a thickness of 80nm(800Å) and a carrier concentration of n=5x10¹⁷cm⁻³.

An n⁻-GaAs ballast resistance layer 86 is formed on emitter layer 85. Ballast resistance layer 86 may have a thickness of 200nm(2000Å) and a carrier concentration of n=10¹⁶cm⁻³ . On ballast resistance layer 86, sequentially stacked are an n⁺-GaAs contact layer 87 and an emitter electrode Ee. Contact layer 87 may have a thickness of 100nm(1000Å) and a carrier concentration of n=5x10¹⁸cm⁻³.

Fig. 11 schematically shows an energy band structure corresponding to the sectional structure of the transistor of Fig. 10. In Figs. 11 and 10, the same or corresponding portions are labeled with the same reference characters. In the energy band structure of Fig. 11, a base/emitter voltage V_{BE} is applied between base layer 84 and contact layer 87, and a collector/emitter voltage V_{CE} is applied between subcollector layer 82 and contact layer 87. A Γ valley and an L valley having an energy level higher than the Γ valley are shown as conduction bands. As described above, in order to prevent extraordinary heat generation of the heterojunction type AlGaAs/GaAs bipolar transistor, a GaAs layer is usually used as a ballast resistance having the same conductivity type as that of the emitter layer and a carrier concentration lower than that of the emitter layer.

In order to operate the heterojunction type AlGaAs/GaAs bipolar transistor stably, it is necessary to block a positive feedback causing extraordinary heat generation. To do so, it is necessary to prevent increase in a collector current caused by a rise of temperature of the transistor. In order to prevent such increase in a collector current by a rise of temperature, a ballast resistance as described above is used. Since the ballast resistance also serves as a parasitic resistance of the transistor, however, the ballast resistance deteriorates the characteristics of the bipolar transistor.

Therefore, it is desired to have a ballast resistance having a low resistance value in a normal operative state where the temperature of the transistor is low, and having a high resistance value in a state of extraordinary heat generation where the temperature of the transistor is high. In other words, a ballast resistance having a large temperature coefficient of a resistance value is desired. However, the conventionally used GaAs ballast resistance layer has a relatively small temperature coefficient of approximately 0.001°C⁻¹.

### SUMMARY OF THE INVENTION

It is an object of the present invention to provide a heterojunction type bipolar transistor having a ballast resistance of an excellent characteristic.

The present invention provides the heterojunction type AlGaAs/GaAs bipolar transistor defined by claim 1.

The sub-claims 2 to 8 relate to embodiments of the invention.

In the AlGaAs/GaAs bipolar transistor according to the present invention, the n-Al_{y}Gal_{1-y}As ballast resistance layer has a positive temperature coefficient (dR/dT) x (1/R) larger than that of the n⁻-GaAs ballast resistance layer, wherein R is a resistance and T is a temperature. In the n-Al_{y}Ga_{1-y}As ballast resistance layer, by selecting the Al concentration y, the energy gap between valleys of a conduction band can be adjusted. When the energy gap between valleys is small, more electrons are thermally excited on the upper valley with increase in the temperature. Effective mass of electrons increases, and mobility of the electrons decreases, resulting in increase in resistance of the n-Al_{y}Ga_{1-y}As ballast resistance layer.

More specifically, the n-Al_{y}Ga_{1-y}As ballast resistance layer has a substantially larger resistance in high temperature as compared to the conventional n⁻-GaAs ballast resistance layer. Therefore, it is possible to more reliably prevent extraordinary heat generation caused by a positive feedback of the collector current in high temperature, making it possible to implement thermally stable operation of the bipolar transistor.

### BRIEF DESCRIPTION OF THE DRAWINGS

Fig. 1 is a schematic sectional view showing an AlGaAs/GaAs bipolar transistor according to one embodiment of the present invention.

Fig. 2 is a diagram showing an energy band structure corresponding to the sectional structure of the transistor of Fig. 1.

Fig. 3 is a graph showing I_{C}-V_{CE} characteristics in such a transistor as shown in Fig. 1.

Fig. 4 is a graph showing the I_{C}-V_{CE} characteristics in a conventional transistor not including a ballast resistance layer.

Fig. 5 is a graph showing an energy gap between a conduction band and a valence band depending on an Al concentration y in n-Al_{y}Ga_{1-y}As.

Fig. 6 is a diagram of an energy band showing electron distribution in n-GaAs at 300K and 400K.

Fig. 7 is a diagram of an energy band showing electron distribution in n-Al_{0.35}Ga_{0.65}As at 300K and 400K.

Fig. 8 is a graph showing an influence of the Al concentration y in n-Al_{y}Ga_{1-y}As on the relationship between temperature and resistivity.

Fig. 9 is a graph showing an influence of the Al concentration y in n-Al_{y}Ga_{1-y}As on the relationship between a temperature coefficient of resistance and temperature.

Fig. 10 is a schematic sectional view showing a conventional AlGaAs/GaAs bipolar transistor including a ballast resistance layer.

Fig. 11 is a diagram showing an energy band structure corresponding to the sectional structure of Fig. 10.

### DESCRIPTION OF THE PREFERRED EMBODIMENTS

Fig. 1 schematically shows a sectional structure of a heterojunction type AlGaAs/GaAs bipolar transistor according to one embodiment of the present invention. In this transistor, on a semi-insulating GaAs substrate 11, formed is an n⁺-GaAs subcollector layer 12. Subcollector layer 12 may have a thickness of 500nm(5000Å) and an n type carrier concentration of n=5x10¹⁸cm⁻³, for example. On subcollector layer 12, formed are an n-GaAs collector layer 13 and a collector electrode Ec. Collector layer 13 may have a thickness of 500nm(5000Å) and a carrier concentration of n=5x10¹⁶cm⁻³.

On collector layer 13, formed is a p⁺-GaAs base layer 14. Base layer 14 may have a thickness of 70nm(700Å) and a p type carrier concentration of p=4x10¹⁹cm⁻³.

On base layer 14, formed is an n-AlₓGa₁₋ₓAs emitter layer 15. Emitter layer 15 preferably has an Al concentration of x=0.3. Emitter layer 15 may have a thickness of 80nm(800Å)and a carrier concentration of n=5x10¹⁷cm⁻³.

An n-Al_{y}Ga_{1-y}As ballast resistance layer 16 is formed on emitter layer 15. Ballast resistance layer 16 preferably has an Al concentration of y=0.35. Ballast resistance layer 16 may have a thickness of 200nm(2000Å)and a carrier concentration of n=10¹⁷cm⁻³.

An n-Al_{z}Ga_{1-z}As graded layer 17 is formed on ballast resistance layer 16. Graded layer 17 may have a thickness of 500nm(500Å) and a carrier concentration of n=10¹⁸cm⁻³. On graded layer 17, formed is an n⁺-GaAs contact layer 18 to be connected to the emitter electrode Ee. Contact layer 18 may have a thickness of 100nm(1000Å) and a carrier concentration of n=5x10¹⁸cm⁻³.

Ballast resistance layer 16 has a resistance higher than that of emitter layer 15. The resistance of ballast resistance layer 16 can be increased by lowering the carrier concentration as compared to emitter layer 15. The resistance of ballast resistance layer 16 can be increased, however, by increasing the Al concentration y a little. The carrier concentration does not necessarily have to be lowered. More specifically, ballast resistance layer 16 must have a resistance higher than that of emitter layer 15, but the carrier concentration in the ballast resistance layer does not necessarily have to be lowered as compared to the emitter layer.

Graded layer 17 is provided to reduce discontinuity in the energy band between ballast resistance layer 16 and contact layer 18. Therefore, the Al concentration z in graded layer 17 is gradually changed from z=y on the side in contact with ballast resistance layer 16 to z=0 on the side in contact with contact layer 18. The Al concentration z may be changed in a linear, curved or stepped manner. Although graded layer 17 is preferably provided to reduce discontinuity in the energy band between ballast resistance layer 16 and contact layer 18 as described above, it is not necessarily required.

The heterojunction type AlGaAs/GaAs bipolar transistor as shown in Fig. 1 can be formed with wellknown methods, an MOCVD (Metal Organic Chemical Vapor Deposition) method and a mesa etching method. Silicon can be used as an n type dopant, and carbon can be used as a p type dopant.

Fig. 2 shows an energy band profile corresponding to the sectional structure of such a transistor as shown in Fig. 1. In Fig. 2, the base/emitter voltage V_{BE} is applied between base layer 14 and contact layer 18, and the collector/emitter voltage V_{CE} is applied between subcollector layer 12 and contact layer 18. A Γ valley and an L valley having an energy level higher than that of the Γ valley are shown as conduction bands. In comparison of Figs. 2 and 11, energy levels of the Γ valley and the L valley in n-Al_{y}Ga_{1-y}As ballast resistance layer 16 are more closely adjacent to each other as compared in an n⁻-GaAs ballast resistance layer 86. Therefore, as compared to the case of n⁻-GaAs ballast resistance layer 86, electrons are more easily excited from the Γ valley at a lower level to the L valley at a higher level with increase in temperature in n-Al_{y}Ga_{1-y}As ballast resistance layer 16. It is understood that because of reduction of mobility due to increase in effective mass of excited electrons, n-Al_{y}Ga_{1-y}As ballast resistance layer 16 has a rapid increase in resistance with rise of temperature as compared to n⁻-GaAs ballast resistance layer 86.

Fig. 3 is a graph showing characteristics of such a transistor as shown in Fig. 1. The abscissa denotes the collector/emitter voltage V_{CE}, and the ordinate denotes the collector current I_{C} (mA). In Fig. 3, n-AlₓGa₁₋ₓAs emitter layer 15 has an Al concentration of x=0.3, and n-Al_{y}Ga_{1-y}As ballast resistance layer 16 has an Al concentration of y=0.35. Various curves in Fig. 3 show I_{C}-V_{CE} characteristics of the transistor under various base/emitter voltages V_{BE}. More specifically, in a region where the collector/emitter voltage V_{CE} is relatively low, the collector current I_{C} increases in proportion to V_{CE}. However, when the collector/emitter voltage V_{CE} exceeds a certain level, the collector current I_{C} or the rate of increase of the collector current decreases, and extraordinary heat generation of the transistor is prevented.

Fig. 4 is a graph similar to that of Fig. 3, showing the I_{C}-V_{CE} characteristics in the AlGaAs/GaAs bipolar transistor not including ballast resistance layer 16. In the transistor shown in Fig. 4, the collector current I_{C} rapidly increases with increase in the collector/emitter voltage V_{CE}. It is understood that the transistor has unstable characteristics. In Fig. 4, two curves terminate at I_{C}=100.0mA. This is because a protecting circuit of the measurement device worked at that collector current value. Two other curves show decrease in collector current at high voltage V_{CE}. This is due to base current limiting protection circuitry in the measurement device. As is clear from the above, the heterojunction type bipolar transistor not having a ballast resistance layer is likely to generate extraordinary heat due to structural nonuniformity. In particular, it is difficult to obtain thermally stable characteristics without ballast resistance in a transistor having a plurality of emitter electrodes in a shape of finger.

According to the analysis of the inventors, an n-Al_{y}Ga_{1-y}As ballast resistance layer may have a temperature coefficient larger than that of a conventional n⁻-GaAs ballast resistance layer in a region of a temperature up to approximately 500K where an AlGaAs/GaAs bipolar transistor is usually used. The n-Al_{y}Ga_{1-y}As ballast resistance layer may have a temperature coefficient approximately ten times larger than that of the n⁻-GaAs ballast resistance layer at approximately 350K. The Al concentration y in the n-Al_{y}Ga_{1-y}As ballast resistance layer has only to be in the range of 0<y≤0.45, more preferably in the range of 0.2<y<0.45, and most preferably y=0.35. Description will be given of the reason therefore hereinafter.

In the graph of Fig. 5, shown is change of energy levels of three kinds of conduction bands of the Γ valley the L valley and the X valley in n-Al_{y}Ga_{1-y}As ballast resistance layer 16. The abscissa represents the Al concentration y in the n-Al_{y}Ga_{1-y}As ballast resistance layer, and the ordinate represents an energy difference E between the top of a valence band and the bottom of three kinds of conduction bands. When the Al concentration y is in the range of 0<y≤0.45, the energy level of the Γ valley is lower than those of the L valley and the X valley. As the Al concentration y approaches 0.45, the energy difference between valleys becomes small. More specifically, at certain electron concentration and temperature, it becomes easier to excite electrons from the Γ valley to a valley at a higher level as the Al concentration y increases. As a result, the ballast resistance rapidly increases. However, if the Al concentration y exceeds 0.45, there is no energy difference between valleys and the ballast resistance will not increase.

Fig. 6 schematically shows a state of distribution of electrons in n⁻-GaAs ballast resistance layer 86. At the temperature of 300K, all the electrons are distributed in a lower region of the Γ valley E_{CΓ}, and no electrons are distributed in the L valley E_{CL} and the X valley E_{CX}. Even at the temperature of 400K, most electrons are distributed in the Γ valley.

Fig. 7 is a diagram similar to that of Fig. 6, showing a state of distribution of electrons in n-Al_{0.35}Ga_{0.65}As ballast resistance layer 16. In Fig. 7, as compared to the case of Fig. 6, the energy gap between valleys is substantially reduced. Therefore, even at the temperature of 300K, electrons are not distributed only in the Γ valley. Thermally excited electrons are also distributed in the L valley and the X valley. At the temperature of 400K, electrons are greater in number in the L valley and the X valley than in the Γ valley. The effective mass of electrons is greater in the L valley and the X valley than in Γ valley, and the average mobility of electrons excited in the Γ valley and the X valley is reduced. As a result, the resistance of n-Al_{0.35}Ga_{0.65}As ballast resistance layer 16 rapidly increases.

In the graph of Fig. 8, the relationship between temperature T and resistivity ρ in n-Al_{y}Ga_{1-y}As is schematically shown. The abscissa represents the temperature T, and the ordinate represents the resistivity ρ. As is clear from Fig. 8, when the Al concentration is y=0.0, the resistivity ρ in a region of a low temperature has a small value. Even if the temperature rises, the resistivity ρ does not increase so much. When the Al concentration is y=0.35, the resistivity ρ in a region of a low temperature has a small value. However, the resistivity ρ rapidly increases with a rise of the temperature. When the Al concentration is y=0.5, the resistivity ρ has a relatively large value even in a region of a low temperature. The resistivity does not increase so much even if the temperature rises.

In the graph of Fig. 9, the relationship between the temperature T and the temperature coefficient (dR/dT) x (1/R) of the resistance R in n-Al_{y}Ga_{1-y}As is shown. The abscissa represents the temperature T, and the ordinate represents the temperature coefficient (dR/dT) x (1/R). When the Al concentration is y=0.0 or y=0.5, the temperature coefficient of the resistance R slightly increases with a rise of the temperature. On the other hand, when the Al concentration is y = 0.35, the temperature coefficient of the resistance R rapidly increases with a rise of the temperature. The temperature coefficient reaches the peak between 300K and 400K, and then decreases as the temperature increases. It will be understood from Fig. 9 that the temperature coefficient of the resistance in ballast resistance layer 16 can be increased by appropriately selecting the Al concentration y in n-Al_{y}Ga_{1-y}As.

In selecting the Al concentration y in n-Al_{y}Ga_{1-y}As ballast resistance layer 16, the Al concentration y does not have to be constant in the direction of thickness of ballast resistance layer 16. The Al concentration y may be changed if desired.

As described above, in the heterojunction type AlGaAs/GaAs bipolar transistor according to the present invention, the n-Al_{y}Ga_{1-y}As ballast resistance layer has a preferably low resistance in a region of a low temperature, and has a sufficiently high resistance in a state of a high temperature. Therefore, non-uniformed current distribution in the transistor can be prevented. As a result, an AlGaAs/GaAs bipolar transistor of high reliability can be obtained which can implement thermally stable operation by having a low parasitic resistance in a state of a low temperature, and by preventing extraordinary heat generation in a state of high temperature.

Although an embodiment of the present invention has been described and illustrated in detail, it is clearly understood that the same is by way of illustration and example only and is not to be taken by way of limitation, the scope of the present invention being defined by the terms of the appended claims.

## Claims (Claims for the following Contracting State(s): DE, FR, GB)

1. A heterojunction bipolar transistor, comprising:
an n-GaAs collector layer (13), a p⁺-GaAs base layer (14), and an n-AlₓGa₁₋ₓAS emitter layer (15) stacked sequentially, said n-AlₓGa₁₋ₓAs emitter layer (15) having an Al concentration x in the range of x > 0 ; and
an n-Al_{y}Ga_{1-y}As ballast resistance layer (16) formed on said emitter layer (15);
wherein said ballast resistance layer (16) has an Al concentration y in the range of 0<y≤0.4, and a resistance higher than that of said emitter layer (15).

2. The bipolar transistor as recited in claim 1, wherein the Al concentration x in said emitter layer (15) is 0.3.

3. The bipolar transistor as recited in claim 1, wherein the Al concentration y in said ballast resistance layer (16) changes in a direction of thickness.

4. The bipolar transistor as recited in claim 1, further comprising:
an n-Al_{z}Ga_{1-z}As graded layer (17) formed on said ballast resistance layer (16); and
an n⁺-GaAs contact layer (18), formed on said graded layer (17), and connected to an emitter electrode (Ee);
wherein said graded layer (17) has an Al concentration z which gradually changes from z=y on a side in contact with said ballast resistance layer (16) to z=0 on a side in contact with said contact layer (18).

5. The bipolar transistor as recited in claim 4, wherein said ballast resistance layer (16) has a carrier concentration lower than those of said emitter layer (15) and said graded layer (17).

6. The bipolar transistor as recited in claim 1, wherein said collector layer (13) is formed on an n⁺-GaAs subcollector layer (12) connected to a collector electrode (Ec).

7. The bipolar transistor as recited in claim 1, wherein the Al concentration y in said ballast resistance layer (16) lies in the range 0.2<y≤0.4.

8. The bipolar transistor as recited in claim 1, wherein the Al concentration y in said ballast resistance layer (16) is about 0.35.

## Claims (Claims for the following Contracting State(s): SE)

1. A heterojunction bipolar transistor, comprising:
an n-GaAs collector layer (13), a p⁺-GaAs base layer (14), and an n-AlₓGa₁₋ₓAs emitter layer (15) stacked sequentially, said n-AlₓGa₁₋ₓAs emitter layer (15) having an Al concentration x in the range of x > 0 ; and
an n-Al_{y}Ga_{1-y}As ballast resistance layer (16) formed on said emitter layer (15);
wherein said ballast resistance layer (16) has an Al concentration y in the range of 0<y≤0.45, and a resistance higher than that of said emitter layer (15).

2. The bipolar transistor as recited in claim 1, wherein the Al concentration x in said emitter layer (15) is 0.3.

3. The bipolar transistor as recited in claim 1, wherein the Al concentration y in said ballast resistance layer (16) changes in a direction of thickness.

4. The bipolar transistor as recited in claim 1, further comprising:
an n-Al_{z}Ga_{1-z}As graded layer (17) formed on said ballast resistance layer (16); and
an n⁺-GaAs contact layer (18), formed on said graded layer (17), and connected to an emitter electrode (Ee);
wherein said graded layer (17) has an Al concentration z which gradually changes from z=y on a side in contact with said ballast resistance layer (16) to z=0 on a side in contact with said contact layer (18).

5. The bipolar transistor as recited in claim 4, wherein said ballast resistance layer (16) has a carrier concentration lower than those of said emitter layer (15) and said graded layer (17).

6. The bipolar transistor as recited in claim 1, wherein said collector layer (13) is formed on an n⁺-GaAs subcollector layer (12) connected to a collector electrode (Ec).

7. The bipolar transistor as recited in claim 1, wherein the Al concentration y in said ballast resistance layer (16) lies in the range 0.2<y≤0.45.

8. The bipolar transistor as recited in claim 1, wherein the Al concentration y in said ballast resistance layer (16) is about 0.35.

## Patentansprüche (Patentansprüche für folgende(n) Vertragsstaat(en): DE, FR, GB)

1. Bipolartransistor mit Heteroübergang, mit:
- einer Kollektorschicht (13) aus n-GaAs, einer Basisschicht (14) aus p⁺-GaAs und einer Emitterschicht (15) aus n-AlₓGa₁₋ₓAs, die aufeinanderfolgend aufeinandergestapelt sind, wobei die Emitterschicht (15) aus n-AlₓGa₁₋ₓAs eine Al-Konzentration x im Bereich x > 0 aufweist; und
- einer Ballastwiderstandsschicht (16) aus n-Al_{y}Ga_{1-y}As, die auf der Emitterschicht (15) ausgebildet ist;
- wobei die Ballastwiderstandsschicht (16) eine Al-Konzentration y im Bereich von 0 < y ≤ 0,4 und einen Widerstand über dem der Emitterschicht (15) aufweist.

2. Bipolartransistor nach Anspruch 1, bei dem die Al-Konzentration x in der Emitterschicht (15) 0,3 beträgt.

3. Bipolartransistor nach Anspruch 1, bei dem sich die Al-Konzentration y in der Ballastwiderstandsschicht (16) in der Dickenrichtung ändert.

4. Bipolartransistor nach Anspruch 1, ferner mit:
- einer Gradientenschicht (17) aus n-Al_{z}Ga_{1-z}As, die auf der Ballastwiderstandsschicht (16) ausgebildet ist; und
- einer Kontaktschicht (18) aus n⁺-GaAs, die auf der Gradientenschicht (17) ausgebildet ist und mit einer Emitterelektrode (Ee) verbunden ist;
- wobei die Gradientenschicht (17) eine Al-Konzentration z aufweist, die sich von z = y auf der Seite, die in Kontakt mit der Ballastwiderstandsschicht (16) steht, auf z = 0 auf der Seite in Kontakt mit der Kontaktschicht (18) ändert.

5. Bipolartransistor nach Anspruch 4, bei der die Ballastwiderstandsschicht (16) eine Ladungsträgerkonzentration unter denjenigen der Emitterschicht (15) und der Gradientenschicht (17) aufweist.

6. Bipolartransistor nach Anspruch 1, bei der die Kollektorschicht (13) auf einer Subkollektorschicht (12) aus n⁺-GaAs ausgebildet ist, die mit einer Kollektorelektrode (Ec) verbunden ist.

7. Bipolartransistor nach Anspruch 1, bei dem die Al-Konzentration y in der Ballastwiderstandsschicht (16) im Bereich 0,2 < y ≤ 0,4 liegt.

8. Bipolartransistor nach Anspruch 1, bei dem die Al-Konzentration y in der Ballastwiderstandsschicht (16) ungefähr 0,35 beträgt.

## Patentansprüche (Patentansprüche für folgende(n) Vertragsstaat(en): SE)

1. Bipolartransistor mit Heteroübergang, mit:
- einer Kollektorschicht (13) aus n-GaAs, einer Basisschicht (14) aus p⁺-GaAs und einer Emitterschicht (15) aus n-AlₓGa₁₋ₓAs, die aufeinanderfolgend aufeinandergestapelt sind, wobei die Emitterschicht (15) aus n-AlₓGa₁₋ₓAs eine Al-Konzentration x im Bereich x > 0 aufweist; und
- einer Ballastwiderstandsschicht (16) aus n-Al_{y}Ga_{1-y}As, die auf der Emitterschicht (15) ausgebildet ist;
- wobei die Ballastwiderstandsschicht (16) eine Al-Konzentration y im Bereich von 0 < y ≤ 0,45 und einen Widerstand über dem der Emitterschicht (15) aufweist.

2. Bipolartransistor nach Anspruch 1, bei dem die Al-Konzentration x in der Emitterschicht (15) 0,3 beträgt.

3. Bipolartransistor nach Anspruch 1, bei dem sich die Al-Konzentration y in der Ballastwiderstandsschicht (16) in der Dickenrichtung ändert.

4. Bipolartransistor nach Anspruch 1, ferner mit:
- einer Gradientenschicht (17) aus n-Al_{z}Ga_{1-z}As, die auf der Ballastwiderstandsschicht (16) ausgebildet ist; und
- einer Kontaktschicht (18) aus n⁺-GaAs, die auf der Gradientenschicht (17) ausgebildet ist und mit einer Emitterelektrode (Ee) verbunden ist;
- wobei die Gradientenschicht (17) eine Al-Konzentration z aufweist, die sich von z = y auf der Seite, die in Kontakt mit der Ballastwiderstandsschicht (16) steht, auf z = 0 auf der Seite in Kontakt mit der Kontaktschicht (18) ändert.

5. Bipolartransistor nach Anspruch 4, bei der die Ballastwiderstandsschicht (16) eine Ladungsträgerkonzentration unter denjenigen der Emitterschicht (15) und der Gradientenschicht (17) aufweist.

6. Bipolartransistor nach Anspruch 1, bei der die Kollektorschicht (13) auf einer Subkollektorschicht (12) aus n⁺-GaAs ausgebildet ist, die mit einer Kollektorelektrode (Ec) verbunden ist.

7. Bipolartransistor nach Anspruch 1, bei dem die Al-Konzentration y in der Ballastwiderstandsschicht (16) im Bereich 0,2 < y ≤ 0,45 liegt.

8. Bipolartransistor nach Anspruch 1, bei dem die Al-Konzentration y in der Ballastwiderstandsschicht (16) ungefähr 0,35 beträgt.

## Revendications (Revendications pour l'(les) Etat(s) contractant(s) suivant(s): DE, FR, GB)

1. Transistor bipolaire à hétérojonction comprenant :
une couche de collecteur en n-GaAs (13), une couche de base en p⁺-GaAs (14) et une couche d'émetteur en n-AlₓGa₁₋ₓAs (15) empilées successivement, ladite couche d'émetteur en n-AlₓGa₁₋ₓAs (15) ayant une concentration x en Al dans la plage de x>0 ; et
une couche de résistance de ballast en n-Al_{y}Ga_{1-y}As (16) formée sur ladite couche d'émetteur (15) ;
dans lequel ladite couche de résistance de ballast (16) a une concentration y en Al dans la plage de 0<y≤0,4, et une résistance supérieure à celle de ladite couche d'émetteur (15).

2. Transistor bipolaire selon la revendication 1, dans lequel la concentration x en Al dans ladite couche d'émetteur (15) est de 0,3.

3. Transistor bipolaire selon la revendication 1, dans lequel la concentration y en Al dans ladite couche de résistance de ballast (16) varie dans la direction de l'épaisseur.

4. Transistor bipolaire selon la revendication 1, comprenant en outre :
une couche progressive en n-Al_{z}Ga_{1-z}As (17) formée sur ladite couche de résistance de ballast (16) ; et
une couche de contact en n⁺-GaAs (18), formée sur ladite couche progressive (17), et connectée à une électrode d'émetteur (Ee) ;
dans lequel ladite couche progressive (17) a une concentration z en Al qui varie progressivement de z=y sur une face en contact avec ladite couche de résistance de ballast (16) à z=0 sur une face en contact avec ladite couche de contact (18).

5. Transistor bipolaire selon la revendication 4, dans lequel ladite couche de résistance de ballast (16) a une concentration en porteurs inférieure à celle de ladite couche d'émetteur (15) et à celle de ladite couche progressive (17).

6. Transistor bipolaire selon la revendication 1, dans lequel ladite couche de collecteur (13) est formée sur une couche de sous-collecteur en n⁺-GaAs (12) connectée à une électrode de collecteur (Ec).

7. Transistor bipolaire selon la revendication 1, dans lequel la concentration y en Al dans ladite couche de résistance de ballast (16) se situe dans la plage définie par 0,2<y≤0,4.

8. Transistor bipolaire selon la revendication 1, dans lequel la concentration y en Al dans ladite couche de résistance de ballast (16) est d'environ 0,35.

## Revendications (Revendications pour l'(les) Etat(s) contractant(s) suivant(s): SE)

1. Transistor bipolaire à hétérojonction comprenant :
une couche de collecteur en n-GaAs (13), une couche de base en p⁺-GaAs (14) et une couche d'émetteur en n-AlₓGa₁₋ₓAs (15) empilées successivement, ladite couche d'émetteur en n-AlₓGa₁₋ₓAs (15) ayant une concentration x en Al dans la plage de x>0 ; et
une couche de résistance de ballast en n-Al_{y}Ga_{1-y}As (16) formée sur ladite couche d'émetteur (15) ;
dans lequel ladite couche de résistance de ballast (16) a une concentration y en Al dans la plage de 0<y≤0,45, et une résistance supérieure à celle de ladite couche d'émetteur (15).

2. Transistor bipolaire selon la revendication 1, dans lequel la concentration x en Al dans ladite couche d'émetteur (15) est de 0,3.

3. Transistor bipolaire selon la revendication 1, dans lequel la concentration y en Al dans ladite couche de résistance de ballast (16) varie dans la direction de l'épaisseur.

4. Transistor bipolaire selon la revendication 1, comprenant en outre :
une couche progressive en n-Al_{z}Ga_{1-z}As (17) formée sur ladite couche de résistance de ballast (16) ; et
une couche de contact en n⁺-GaAs (18), formée sur ladite couche progressive (17), et connectée à une électrode d'émetteur (Ee) ;
dans lequel ladite couche progressive (17) a une concentration z en Al qui varie progressivement de z=y sur une face en contact avec ladite couche de résistance de ballast (16) à z=0 sur une face en contact avec ladite couche de contact (18).

5. Transistor bipolaire selon la revendication 4, dans lequel ladite couche de résistance de ballast (16) a une concentration en porteurs inférieure à celle de ladite couche d'émetteur (15) et à celle de ladite couche progressive (17).

6. Transistor bipolaire selon la revendication 1, dans lequel ladite couche de collecteur (13) est formée sur une couche de sous-collecteur en n⁺-GaAs (12) connectée à une électrode de collecteur (Ec).

7. Transistor bipolaire selon la revendication 1, dans lequel la concentration y en Al dans ladite couche de résistance de ballast (16) se situe dans la plage définie par 0,2<y≤0,45.

8. Transistor bipolaire selon la revendication 1, dans lequel la concentration y en Al dans ladite couche de résistance de ballast (16) est d'environ 0,35.
